# EUROPEAN PATENT SPECIFICATION

(11) **EP 0 520 105 B1**
(45) Date of publication and mention of the grant of the patent: **30.08.1995**
(21) Application number: 91305897.0
(22) Date of filing: 28.06.1991
(51) Int. Cl.: H01L 21/00

(54) **A wafer basket**
Trägerkassette für Halbleiterscheiben
Nacelle pour plaquettes semiconductrices

(43) Date of publication of application: 30.12.1992
(73) Proprietor: SHIN-ETSU HANDOTAI COMPANY LIMITED, Chiyoda-ku Tokyo (JP)
(72) Inventor: Ogino, Nobuyoshi, Musashino-shi, Tokyo (JP)
(74) Representative: Pacitti, Pierpaolo A.M.E.

(56) References cited:
- WO-A-89/00333
- US-A- 4 471 716
- IBM TECHNICAL DISCLOSURE BULLETIN. vol. 31, no. 7, December 1988, NEW YORK US pages 134 - 135; 'wafer carrier for on center wet processing'

## Description

### BACKGROUND OF THE INVENTION

The present invention relates to a wafer basket for holding, cleaning, drying, storing and transporting a large number of semiconductor wafers. More particularly, the invention relates to a wafer basket which is designed to improve cleaning and drying conditions for the wafers held in it.

### (Prior Art)

A wafer basket is a box-like rack for containing semiconductor wafers, and is commonly molded integrally of PFA (a copolymer synthesized from perfluoroalkylvinyl ether and tetrafluoroethylene), which is an excellent material in chemical resistance and heat resistance. In construction the wafer basket comprises numerous shelves for receiving wafers in a row, each shelf consisting of a groove defined by a pair of neighboring partition ribs which ribs are formed at regular intervals. The wafer basket is also a vehicle means for transporting the wafers it contains.

A typical conventional wafer basket is described as follows. Being box-like, a wafer basket has four walls, of which two are called side walls. The other two walls parallel to each other are called a front wall and a rear wall, respectively. The side walls are also parallel to each other except for the lower portions where they are bent and curved inwardly in a manner such that a wafer-sized circle may be roughly inscribed to the inner surfaces of the side walls. The inner surfaces of the side walls are formed with vertical partition ribs in a manner such that the ribs formed on one side wall are in mirror symmetry with those formed on the other side wall, and such that each pair of neighboring partition ribs on one side wall cooperate with that pair on the other side wall in mirror-symmetric relation to the former to define a groove within themselves suitable for receiving the edge portion of a wafer, and the wafers thus received are constrained to stand at regular intervals and parallel to the front and rear walls. Slit holes are made along the grooves in either side wall such that the slit holes render the grooves bottomless where the slits are made. These slits provide passages for the treating liquid to enter the wafer basket when the basket is steeped in the treating liquid.

The wafer basket has no ceiling or bottom floor, but the lower bent portions of the side walls provide a support means so that the wafers do not fall through the wafer basket. Thus, each groove in the bent portions of the side walls holds the wafer between the ribs, and the wafer received fits therein in a manner such that considerable portions of the edge of the wafer which are inside the grooves formed in the curved lower portions of the side walls are in contact with the bottoms or the side slopes of the grooves between the ribs. Thus, the downward movement of the wafers is checked by the ribs.

Also, the conventional wafer basket is provided with four recesses each at the four top corners, that is, at either top lateral end of the side walls. The recesses are formed in a shape such that they can engage with the hooks of a basket lifter. Thus hooked by the hooks of the basket lifter, the wafer basket is lifted, transported, steeped in a treatment liquid or a cleaning liquid, and suspended in the air for various treatments.

### (Problems the Invention seeks to solve)

However, in the conventional wafer basket as described above, the grooves formed in the lower portions of the side walls are formed in a manner such that the diameter of the circular arcs traced by each curved groove is roughly identical to the diameter of the wafer to be received [ref., for example, Japanese Published Patent Kokoku No. 53-38591 (1978)], so that considerable lengths of the peripheral edge of the wafer are inevitably flanked and contacted by the constricting (converging) sides of the ribs, with the result that during the cleaning operations of the wafers the edges contacted by the ribs or the groove bottoms are only poorly cleaned, and furthermore when the wafer basket is lifted from a cleaning liquid such as deionized water (DI water), the liquid is liable to stay between the edge of the wafer and the ribs so that during the vapor drying operation the remnant liquid leaves stains and particles at the edge of the wafer and prevents proper drying thereof. As a result, the yield of the semiconductor chips obtained from the wafers is reduced and the reliability of the product quality becomes lower.

Also, with the conventional wafer basket, in addition to the bottom hole defined between the lower edges of the side walls, the lengthy slits cut through the groove bottoms provide passages for a liquid to enter the wafer basket when the wafer basket loaded with wafers is steeped in a cleaning liquid or etching liquid during the wafer cleaning operation or wafer etching operation, as well as passages for the liquid to drain when the basket is lifted above the liquid. However, since the slit holes are relatively narrow and the peripheral edges of the wafers nearly plug them, the liquid does not pass through them freely, and when the basket is lifted above the liquid, some liquid tends to be held in the slit holes owing to the capillary phenomenon, so that the basket gets rid of the liquid poorly, and during the vapor drying operation the remnant liquid leaves stains and particles at the edge of the wafer and prevents proper drying thereof.

### SUMMARY OF THE INVENTION

This invention was invented in view of the foregoing circumstances, and it is an object of the invention to provide a wafer basket which is constructed simply and functionally such that a fluid can pass the wafer basket freely and the wafers contained therein are secure from the problems of poor cleaning and drying and thus are free from stains, and also that the weight and cost of the basket are significantly reduced.

### (Means to solve the Problems)

In order to attain the objects of the invention, a wafer basket was newly designed. According to the present design, although the wafer basket is molded integrally of a resin such as PFA like the conventional wafer baskets, it differs from the conventional wafer baskets shown in US-A-4 471 716 in the features of the characterising part of claim 1.

### (Effects of the Invention)

According to the invention, since the dented stay means having semicircular cross section at their upper edges are provided to support the wafers, the wafers mounted on the stay means are virtually in point-wise contact with the stay means, and furthermore, since the vacancies of considerable size are formed where the bent portions of the side walls are removed, considerable lengths of the wafer edges do not have to touch any part of the wafer basket. Consequently, the edges of the wafers are cleaned well during the cleaning operations, and the cleaning liquid scarcely stays on the wafers when the wafer basket is lifted from the cleaning liquid so that no stains are formed during the vapor drying operation. As a result, the wafers are dried properly and are not contaminated with particles so that the yield of the semiconductor chips obtained from the wafers is improved and the reliability of the product quality becomes higher.

Also, according to the invention, since a sizeable vacancy is formed between the side wall and the dented stay means on either side of the wafer basket, the fluid can pass the wafer basket freely, and, thus, when the wafer basket is lifted above the liquid, the wafer basket can get rid of the liquid quickly with the result that the wafers contained therein are secure from the problems of poor cleaning and drying, and thus are free from stains. Since the present wafer basket is simpler, the consumption of the material (PFA) is reduced and thus the weight and cost of the basket are significantly reduced.

Next, an embodiment of the wafer basket of the invention will be described in detail with reference to the attached drawings.

### BRIEF DESCRIPTION OF THE DRAWINGS

Fig. 1 is a longitudinal sectional view of a wafer basket according to the invention (taken on line B - B in Fig. 3);
Fig. 2 is an enlarged detailed view of the portion A of Fig. 1;
Fig. 3 is a side view of the same wafer basket;
Fig. 4 is a top plan view of the same wafer basket;
Fig. 5 is a front view of the same wafer basket as seen in the direction of the arrow C in Fig. 4;
Fig. 6 is a rear view of the same wafer basket as seen in the direction of the arrow D in Fig. 4; and

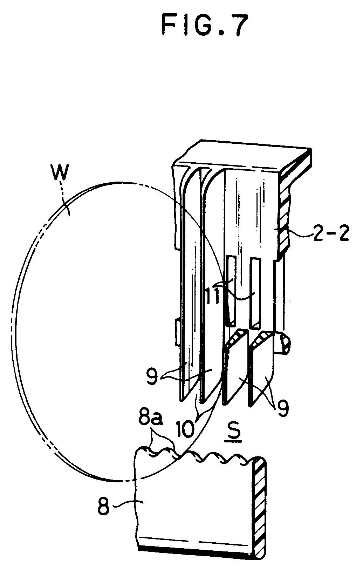

Fig. 7 is a fragmentary perspective view of a side of the same wafer basket seen from the inside.

### DETAILED DESCRIPTION OF THE INVENTION

A wafer basket 1 according to the present invention has side walls 2-1 and 2-2 opposed to and parallel to each other, and a front wall 3-1 and a rear wall 3-2 which are also opposed to and parallel to each other and are integrally formed with the side walls 2-1 and 2-2 to which they are connected normally at the lateral edges. These four walls thus give the wafer basket 1 a box-like configuration; but the wafer basket 1 does not have a ceiling or a floor. Incidentally, the wafer basket 1 is molded integrally of PFA, a fluorine-containing resin, like the conventional wafer baskets.

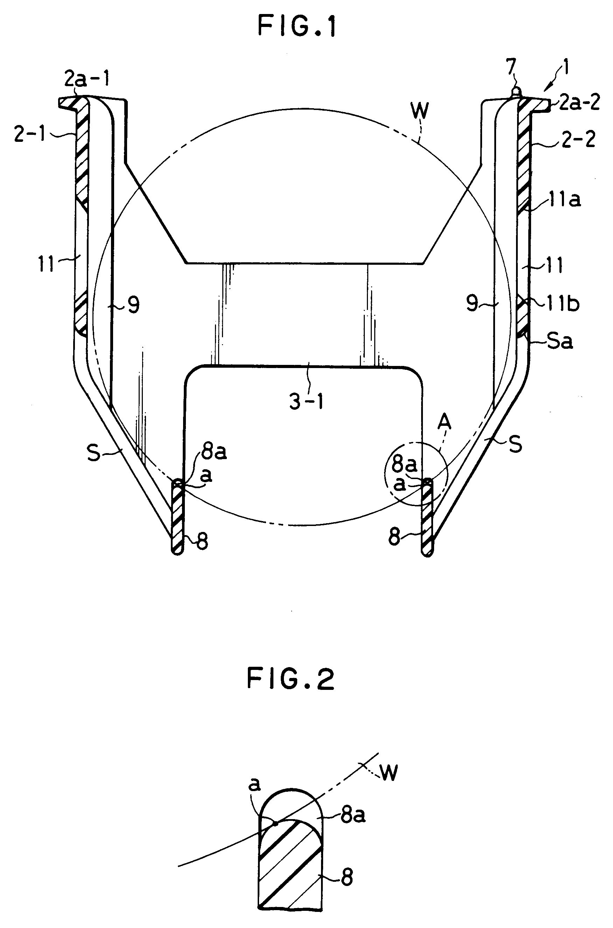

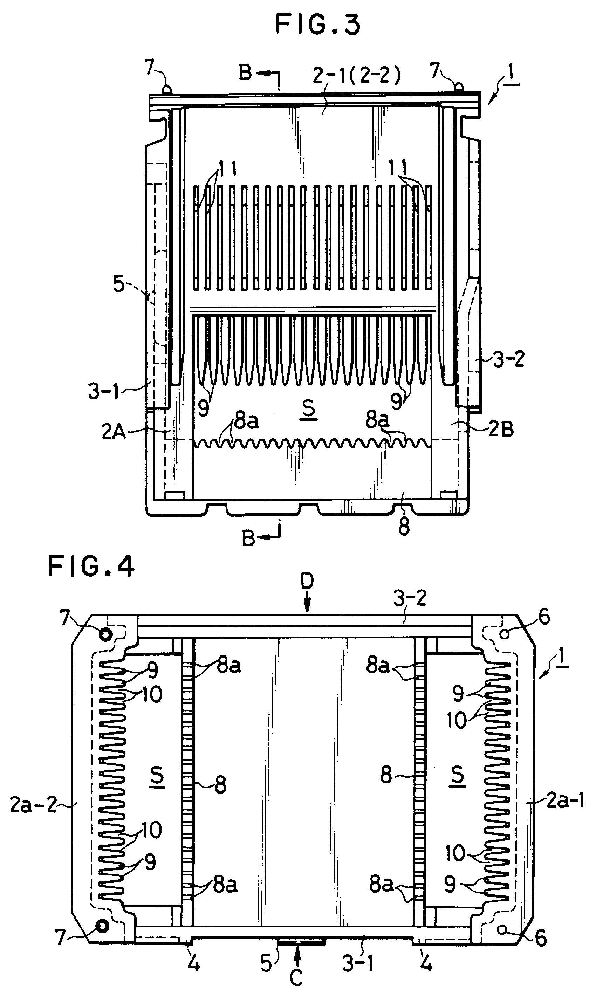

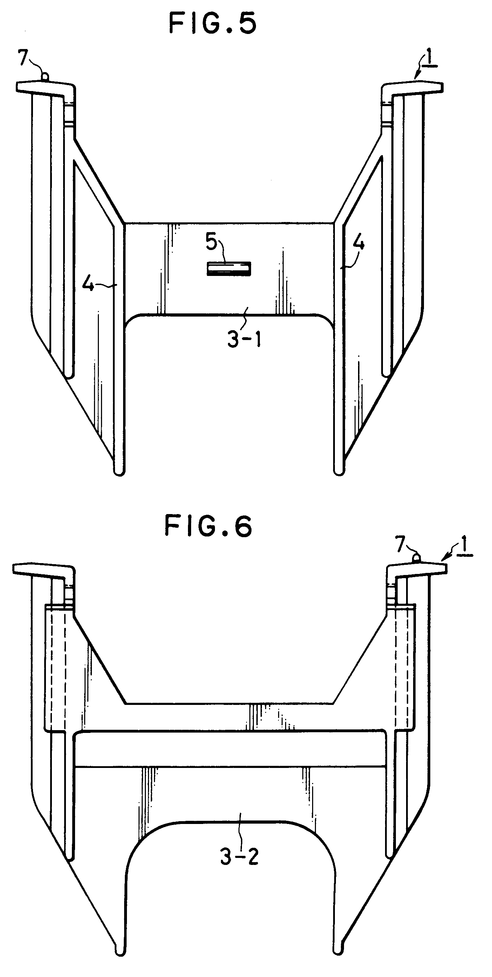

In this embodiment of the invention, the upper and lower portions of the front wall 3-1 and the rear wall 3-2 are substantially removed in a manner such that the remnants of the front and the rear walls look like a letter "H" (ref. Fig. 1). As shown in Figs. 4 and 5, a pair of stiffening ribs 4, 4 are provided across the outer face of the front wall 3-1, and, as shown in Fig. 3 in addition to Figs. 4 and 5, an indexing protrusion 5 in the shape of a half cylinder extending in the direction of the width of the front wall 3-1 is formed in the middle of the generally rectangular portion of the front wall 3-1 which is bounded by the stiffening ribs 4, 4.

The side walls 2-1 and 2-2 are provided with flanges 2a-1 and 2a-2, respectively, which extend horizontally outward from the upper edges of the side walls. As shown in Fig. 4, a small circular bore 6 is provided at either end of the flange 2a-1, for positioning the wafer basket 1. Also, for the same purpose, the other flange 2a-2 is provided with a small round-topped protrusion 7 at either end thereof.

As shown in Figs. 1 and 3, the side walls 2-1 and 2-2 each have a pair of strip-like extensions 2A, 2B which extend from the lower corners of the walls and are bent inwardly in a manner such that a wafer-sized circle may be roughly inscribed to the inner surfaces of the side walls 2-1, 2-2 and the bent extensions 2A, 2B. A plate-like stay 8 is provided at the lower ends of either pair of the extensions 2A, 2B, in a manner such that each stay 8 is passed in the direction normal to the front and rear walls 3-1, 3-2, and extends from the front wall 3-1 to the rear wall 3-2. As shown in Figs. 3 and 4, a space S is defined by the stay 8, the lower edge of the side wall 2-1 or 2-2, and the pair of extensions 2A, 2B on either side of the wafer basket 1. Incidentally, the extensions 2A, 2B can also be considered as flanges extending normally from the front and rear walls, respectively, and the manner of drafting the claims will regard the extensions 2A, 2B as such. Thus, the vacancy S can also be said to be defined by the stay 8, the lower edge of the side wall, and the lower portions of the front and rear walls.

The inner surface of either of the vertical side walls 2-1, 2-2 is formed with wafer-partition ribs 9 each extending vertically from the top of the side wall to a point substantially beyond the lower edge of the side wall. The lower end of each rib is shaped like a knife edge, and disposed in the vacancy S. The ribs 9 (nineteen ribs in this embodiment, as seen in Fig. 4) are arranged in a row at regular intervals from the front wall 3-1 to the rear wall 3-2; and the ribs formed on the side wall 2-1 are in mirror symmetry with the ribs formed on the side wall 2-2. Each pair of neighboring ribs 9, 9 define a groove 10 having a width suitable for receiving in it the edge portion of a wafer W. Since the opposing ribs are mirror-symmetrically formed, the grooves formed on the side wall 2-1 are mirror-symmetric with those formed on the side wall 2-2, so that a wafer W can be received in each pair of opposing grooves. Incidentally, the foremost and the rearmost ribs define similar grooves in cooperation with the partitionable risings raised from the inside surfaces of the side walls, so that the wafer basket 1 can hold twenty wafers at a time in a manner such that the wafers are arranged between the front and rear walls at regular intervals.

The upper edges of the stays 8, 8 are formed with numerous indents 8a at the same regular intervals as the grooves 10 of the side wall are formed so that a wafer received in a certain groove and in the corresponding indent is constrained to stand in parallel to the front and rear walls.

The upper edges of the dented stay means 8, 8 are roughly semicircular when seen in their cross section cut by a plane parallel to the front wall and passing through an indent between any dents, as shown in Fig. 2.

Slit holes 11 are made in the vertical side walls 2-1 and 2-2 such that the slit holes 11 render the grooves 10 bottomless where the slits are made. As shown in the cross-sectional view at Fig. 1, the slit 11 has a slanted upper end face 11a and a slanted lower end face 11b such that it has a profile of diverging externally. Also, the vacancy S has a slanted upper end face Sa, so that it also diverges externally. These lengthy slits 11 provide passages for the treating liquid to enter the wafer basket 1 when the basket is steeped in the treating liquid.

The wafers W are put into the wafer basket 1 by letting them slide down into the grooves 10 formed in the side walls 2-1, 2-2, from above. This downward movement of a wafer W is checked by the stays 8 when the wafer W is received in a dent and mounted on the stays 8. In this manner twenty wafers W are contained in a row in the wafer basket 1, and they are all isolated from the neighboring ones by the partitioning ribs 9.

Each wafer W is only contacted by the stays 8 and by the ribs 9. However, since the upper edges of the stays 8 are semicircular in cross section, the area of the contact is virtually a point a each. Also, since the wafer W is mounted on the stays 8, and the existence of the vacancies S enables substantial portions of the wafer edge to avoid contacting the wafer basket, the contact between the wafer W and the ribs 9 are scanty and temporal. Also, the vacancies S allow quick draining of the wafer basket. Therefore, during the cleaning operations of the wafers almost entire surface of each wafer W is readily and sufficiently rinsed by the cleaning liquid, and when the wafer basket 1 is lifted from the cleaning liquid such as deionized water, the liquid scarcely stays on the wafer W so that during the subsequent vapor drying operation scarce stain or particle is left on the surface of the wafer W, and thus proper drying of the wafer W is facilitated. As a result, the yield of the semiconductor chips obtained from the wafers is improved and the reliability of the product quality becomes higher.

## Claims

1. A wafer basket comprising:
two side walls (2-1, 2-2) facing and parallel to each other which are internally formed with a plurality of vertical ribs (9) arranged at regular intervals to define grooves (10) for reception of wafers, the grooves (10) on one of the side walls (2-1) being in mirror symmetry with the grooves (10) on the other side wall (2-2);
a front wall (3-1) and a rear wall (3-2) facing and parallel to each other and normal to the side walls (2-1, 2-2), the side walls (2-1, 2-2) being held and extending between said front and rear walls (3-1, 3-2);
a pair of parallel stay means (8) held by and extending between said front and rear walls (3-1, 3-2) at a position substantially lower than the lower edges of the side walls (2-1, 2-2) and being substantially closer to each other than the lower edges of the side walls (2-1, 2-2), the configuration of said side walls (2-1, 2-2) and said stay means (8) being such that a wafer sized circle may be roughly inscribed to the inner sides of the side walls (2-1, 2-2) and the upper surfaces of the stay means (8), whereby a wafer (W) received in a pair of corresponding grooves (10) of the side walls (2-1, 2-2) rests upon said stay means (8) and is maintained substantially parallel to the front and rear walls (3-1, 3-2);
wherein the lower edges of the side walls (2-1, 2-2), the lower portions of the front and rear walls (3-1, 3-2) and the stay means (8) cooperate to define substantially large drainage apertures (S); characterised in that:
said stay means (8) are each provided with a plurality of indents (8a) formed along the upper surfaces thereof at the same regular intervals as the grooves (10) between the ribs (9) of the side walls (2-1, 2-2), such that said wafer (W) received in a pair of corresponding grooves (10) of the side walls (2-1, 2-2) rests in a pair of corresponding indents (8a) of said stay means (8); in that:
the upper surfaces of the indented stay means (8) are curved when seen in cross section cut by a plane parallel to said front wall (3-1) and make essentially point contact (a) with said circular wafer (W); in that:
said ribs (9) extend downwardly beyond the lower edges of said side walls (2-1, 2-2) and terminate within the apertures (S) between the lower edges of said side walls (2-1, 2-2) and the upper edges of said stay means (8), those portions of the ribs (9) projecting below the lower edges of the side walls (2-1, 2-2) being shaped so as to lie within the lateral periphery of the basket as defined by the front and rear walls (3-1, 3-2) and the lowermost ends of said ribs (9) being tapered when viewed in a direction normal to said side walls (2-1, 2-2); in that:
said side walls (2-1, 2-2) further include a plurality of vertically extending slits (11) formed in each of said grooves (10) defined by said ribs (9); and in that:
the faces (11a, 11b, Sa) defined by the upper and lower vertical ends of said slits (11) and the lower edge of said side walls (2-1, 2-2) are slanted with respect to said side walls (2-1, 2-2).

2. A wafer basket as claimed in Claim 1 wherein said apertures (S) are defined by the lower ends of the side walls (2-1, 2-2), flanges (2A, 2B) extending normally from the lower portions of the front and rear walls (3-1, 3-2) and the stay means (8).

## Patentansprüche

1. Waferkorb, bestehend aus:
zwei Seitenwänden (2-1, 2-2), die einander gegenüberliegen und parallel zueinander sind und die innen mit einer Vielzahl von vertikalen Rippen (9) ausgebildet sind, welche in regelmäßigen Abständen zur Ausbildung von Nuten (10) für die Aufnahme von Wafers angeordnet sind, wobei die Nuten (10) an der einen der Seitenwände (2-1) spiegelsymetrisch zu den Nuten (10) an der anderen Seitenwand (2-2) sind;
einer Vorderwand (3-1) und einer Rückwand (3-2), die einander gegenüberliegen und parallel zueinander sind und die senkrecht zu den Seitenwänden (2-1, 2-2) sind, wobei die Seitenwände (2-1, 2-2) zwischen den Vorder- und Rückwänden (3-1, 3-2) verlaufen und gehalten sind;
einem Paar paralleler Stegmittel (8), die zwischen den Vorder- und Rückwänden (3-1, 3-2) verlaufen und gehalten sind in einer Position wesentlich niedriger als die unteren Kanten der Seitenwände (2-1, 2-2) und die zueinander wesentlich enger sind als die unteren Kanten der Seitenwände (2-1, 2-2), wobei die Gestaltung der Seitenwände (2-1, 2-2) und der Stegmittel (8) derart ist, daß ein Kreis in der Größe eines Wafers grob in die Innenseiten der Seitenwände (2-1, 2-2) und die Oberseiten der Stegmittel (8) einbeschrieben werden kann, wodurch ein in einem Paar entsprechender Nuten (10) der Seitenwände (2-1, 2-2) aufgenommenes Wafer (W) auf den Stegmitteln (8) ruht und im wesentlichen parallel zu den Vorder- und Rückwänden (3-1, 3-2) beibehalten wird;
wobei die unteren Kanten der Seitenwände (2-1, 2-2), die unteren Bereiche der Vorder- und Rückwände (3-1, 3-2) und die Stegmittel (8) zusammenwirken, um beträchtlich große Drainage-Öffnungen (S) zu definieren;
dadurch gekennzeichnet, daß
die Stegmittel (8) jeweils mit einer Vielzahl von Kerben (8a) versehen sind, die entlang der Oberseiten davon mit denselben gleichmäßigen Abständen wie die Nuten (10) zwischen den Rippen (9) der Seitenwände (2-1, 2-2) ausgebildet sind, sodaß das in einem Paar entsprechender Nuten (10) der Seitenwände (2-1, 2-2) aufgenommene Wafer (W) in einem Paar entsprechender Kerben (8a) der Stegmittel (8) ruht; und daß
die Oberseiten der gekerbten Stegmittel (8) gekrümmt sind bei einer Ansicht in einem Querschnitt, der durch eine Ebene parallel zu der Vorderwand (3-1) geschnitten ist, und sie im wesentlichen einen Punktkontakt (a) mit dem kreisförmigen Wafer (W) besitzen; und daß
die Rippen (9) nach unten verlaufen über die unteren Kanten der Seitenwände (2-1, 2-2) hinaus und innerhalb der Öffnungen (S) zwischen den unteren Kanten der Seitenwände (2-1, 2-2) und den oberen Kanten der Stegmittel (8) enden, wobei die unterhalb der unteren Kanten der Seitenwände (2-1, 2-2) vorstehenden Bereiche der Rippen (9) so geformt sind, daß sie innerhalb des seitlichen Umfangs des Korbes liegen wie definiert durch die Vorder- und Rückwände (3-1, 3-2), und die untersten Enden der Rippen (9) bei einer Ansicht in einer Richtung senkrecht zu den Seitenwänden (2-1, 2-2) spitz zulaufend sind; daß
die Seitenwände (2-1, 2-2) weiterhin eine Vielzahl von vertikal verlaufenden Spitzen (11) aufweisen, die in jeder der durch die Rippen (9) definierten Nuten (10) ausgebildet sind; und daß
die durch die oberen und unteren vertikalen Enden der Schlitze (11) und die untere Kante der Seitenwände (2-1, 2-2) definierten Fronten (11a, 11b, Sa) in Bezug auf die Seitenwände (2-1, 2-2) geneigt sind.

2. Waferkorb nach Anspruch 1, bei welchem die Öffnungen (S) durch die unteren Enden der Seitenwände (2-1, 2-2), Flansche (2A, 2B), die senkrecht von den unteren Bereichen der Vorder- und Rückwände (3-1, 3-2) verlaufen, und die Stegmittel (8) definiert sind.

## Revendications

1. Nacelle pour plaquettes semi-conductrices comprenant :
deux parois latérales (2-1, 2-2) agencées en vis-à-vis et parallèlement l'une à l'autre, présentant sur leurs faces internes respectives une pluralité de nervures verticales (9) agencées à des intervalles réguliers en vue de définir des rainures (10) destinées à recevoir des plaquettes semi-conductrices, les rainures (10) ménagées sur l'une des parois latérales (2-1) et les rainures (10) ménagées sur l'autre paroi latérale (2-2) étant disposées symétriquement par rapport à un plan ;
une paroi antérieure (3-1) et une paroi postérieure (3-2) agencées en vis-à-vis, parallèlement l'une à l'autre et perpendiculairement aux parois latérales (2-1, 2-2), les parois latérales (2-1, 2-2) s'étendant et étant maintenues entre lesdites parois antérieure et postérieure (3-1, 3-2) ;
deux moyens de support (8) parallèles, s'étendant et étant maintenus entre lesdites parois antérieure et postérieure (3-1, 3-2) à une position sensiblement plus basse que les bords inférieurs des parois latérales (2-1, 2-2) et étant sensiblement plus proches l'un de l'autre que les bords inférieurs des parois latérales (2-1, 2-2), lesdites parois latérales (2-1, 2-2) et lesdits moyens de support (8) étant configurés de telle sorte qu'un cercle de la taille d'une plaquette semi-conductrice puisse s'inscrire approximativement dans les côtés internes des parois latérales (2-1, 2-2) et les surfaces supérieures des moyens de support (8), une plaquette semi-conductrice (W) logée dans une paire de rainures correspondantes (10) des parois latérales (2-1, 2-2) reposant sur lesdits moyens de support (8) et étant maintenue sensiblement parallèlement aux parois antérieure et postérieure (3-1, 3-2) ;
les bords inférieurs des parois latérales (2-1, 2-2), les parties inférieures des parois antérieure et postérieure (3-1, 3-2) et les moyens de support (8) définissant ensemble des ouvertures de vidange (S) relativement grandes ; caractérisée en ce que :
chaque moyen de support (8) présente sur sa face supérieure une pluralité d'entailles (8a) ménagées selon les mêmes intervalles réguliers que les rainures (10) définies entre les nervures (9) des parois latérales (2-1, 2-2), de telle sorte que ladite plaquette semi-conductrice (W) logée dans une paire de rainures correspondantes (10) des parois latérales (2-1, 2-2) repose dans une paire d'entailles (8a) correspondantes, ménagées sur lesdits moyens de support (8) ; en ce que
les surfaces supérieures des moyens de support (8), dans lesquels sont pratiquées les entailles, présentent, lorsqu'elles sont vues en coupe selon un plan parallèle à ladite paroi antérieure (3-1), un profil incurvé et sont en contact essentiellement ponctuel (a) avec ladite plaquette semi-conductrice (W) ; en ce que :
lesdites nervures (9) s'étendent vers le bas au-delà des bords inférieurs desdites parois latérales (2-1, 2-2) pour aboutir dans les ouvertures (S), entre les bords inférieurs desdites parois latérales (2-1, 2-2) et les bords supérieurs desdits moyens de support (8), les parties des nervures (9) dépassant au-dessous des bords inférieurs des parois latérales (2-1, 2-2) étant conformées de façon à être comprises dans la périphérie latérale de la nacelle, définie par les parois antérieure et postérieure (3-1, 3-2), et les extrémités inférieures desdites nervures (9) étant biseautées, vues dans une direction normale auxdites parois latérales (2-1, 2-2) ; en ce que :
lesdites parois latérales (2-1, 2-2) comportant également une pluralité de fentes verticales (11) pratiquées dans chacune desdites rainures (10) définies par lesdites nervures (9) ; et en ce que :
les faces (11a, 11b, Sa), définies par les extrémités verticales supérieures et inférieures desdites fentes (11) et le bord inférieur desdites parois latérales (2-1, 2-2), sont inclinées par rapport auxdites parois latérales (2-1, 2-2).

2. Nacelle pour plaquettes semi-conductrices selon la revendication 1, caractérisée en ce que lesdites ouvertures (S) sont définies par les extrémités inférieures des parois latérales (2-1, 2-2), les brides (2A, 2B) s'étendant perpendiculairement depuis les parties inférieures des parois antérieure et postérieure (3-1, 3-2) et les moyens de support (8).
